Europäisches Patentamt

European Patent Office

Office européen des brevets

(19)

(11) **EP 0 746 123 A1**

(12) **EUROPÄISCHE PATENTANMELDUNG**

(43) Veröffentlichungstag:
04.12.1996 Patentblatt 1996/49

(51) Int. Cl.$^6$: **H04J 3/06**, H03M 13/00,
H04L 7/04

(21) Anmeldenummer: 96108119.7

(22) Anmeldetag: 22.05.1996

(84) Benannte Vertragsstaaten:
DE FR GB IT

(30) Priorität: 02.06.1995 DE 19519946

(71) Anmelder: DEUTSCHE THOMSON-BRANDT
GMBH
78048 Villingen-Schwenningen (DE)

(72) Erfinder: Streckenbach, Wulf-Christian
30966 Hemmingen (DE)

(54) **Verfahren zur schnellen Synchronisation empfangener Datenblöcke, die jeweils ein Prüfsummenfeld enthalten, sowie Vorrichtung dazu**

(57)     Durch die Erfindung wird mit geringem Schaltungsaufwand wiederholt eine schnelle Bestimmung der Prüfsumme ermöglicht.

Bei Ungleichheit zwischen einer aus Informationsdaten eines Datenblocks ermittelten Prüfsumme und einem im Datenblock enthaltenen Vergleichswert wird mit jedem weiteren Takt eine neue Prüfsumme gewonnen, indem nur die in Vorberechnungen in Abhängigkeit eines gewählten Generatorpolynoms als änderungsfähig ermittelten Bit der vorangehenden Prüfsumme ausgewählt und zur Bildung der neuen Prüfsumme mit dem zuerst gesendeten Bit des jeweils vorangehenden Datenblocks logisch verknüpft werden.

Anwendbar zum Auffinden eines ATM (Asynchron Transmission Mode)-Zellenanfangs bei Breitband-ISDN-Netzwerken.

Fig.7

EP 0 746 123 A1

**Beschreibung**

Die Erfindung betrifft ein Verfahren zur Synchronisation durch Verifizieren der Prüfsumme eines aus Informationsdaten und einem anschließenden Prüfsummenfeld bestehenden empfangenen Datenblocks nach dem Oberbegriff des Anspruchs 1 und eine Vorrichtung des in Anspruch 1 beschriebenen Verfahrens nach dem Oberbegriff des Anspruchs 3.

In zukünftigen Breitband-ISDN-Netzwerken werden die Nutzdaten in sogenannten ATM (Asynchron Transmission Mode)-Zellen verpackt. Eine solche ATM Zelle besteht aus 53 Bytes, wobei die ersten fünf Bytes den Zellen-Header darstellen. Die ersten vier Bytes beinhalten Informationen über welchen Pfad bzw. Kanal die Daten gesendet werden. Jede Sendestation muß vor dem Versenden einer ATM-Zelle eine Prüfsumme über den gesamten Header errechnen und diese im fünften Byte des Headers ablegen. Um auf der Empfangsseite aus dem seriellen Bitstrom den Beginn einer Zelle erkennen zu können, wird folgender Algorithmus angewandt:

Im sogenannten HUNT-Zustand wird das empfangene Signal Bit für Bit dahingehend untersucht, ob es Teil eines HEC (Header Error Control)-Musters sein könnte. Sobald solch ein HEC-Muster gefunden ist, erfolgt der Übergang in den PRESYNCH-Zustand. Im PRESYNCH-Zustand werden nun, bezogen auf die lokalisierte Zelle, alle weiteren Zellen untersucht. Entsprechen die HEC-Bytes der darauffolgenden sechs Zellen den möglichen Prüfsummen, so wird daraus geschlossen, daß Synchronität zum Zellenstrom erreicht ist und es erfolgt der Übergang in den SYNCH-Zustand. Erfüllen weniger als sechs aufeinanderfolgende Zellen die HEC Bedingung, so kehrt die Empfangsstation wieder in den HUNT-Zustand zurück.

Wird im SYNCH-Zustand die HEC-Bedingung von sieben aufeinanderfolgenden Zellen nicht erfüllt, so wird vom Verlust der Zellensynchronität ausgegangen, und es erfolgt der Übergang in den HUNT Zustand.

Das vorliegende Verfahren befaßt sich mit der ersten Phase der Zellensynchronisation, dem HUNT-Zustand. Auf der Empfangsseite ergibt sich das Problem, daß aus dem unsynchronisierten Bitstrom der Zellenbeginn gefunden werden muß. Da die ersten fünf Bytes einer ATM-Zelle einen Datenblock für den Zellen-Header darstellen, kann der Zellenbeginn durch Auffinden des Headers über die Verifizierung seiner Prüfsumme ermittelt werden.

Dazu wird auf der Empfangsseite die Prüfsumme von jeweils n Bit des empfangenen Bitstromes in der gleichen Weise wie auf der Sendeseite berechnet. Wenn aber nach den ersten n ausgewerteten Bit keine Übereinstimmung der nachfolgend empfangenen o Bit mit den auf der Empfangsseite aus dem Datenstrom berechneten o Bit besteht, so muß die Berechnung der Prüfsumme über n Bit um einen Takt verschoben gegenüber der vorangegangenen Berechnung erneut vorgenommen werden. Um dieses zu ermöglichen wären n * o Bit Schieberegister erforderlich, die jeweils um einen Takt verschoben die Prüfsumme berechnen und mit den empfangenen Daten vergleichen. Dies bedeutet jedoch einen großen Schaltungsaufwand, wenn man die zusätzlich erforderliche zyklisch arbeitende Steuer- und Kontrolllogik berücksichtigt. Eine weitere Möglichkeit könnte ein n Bit langes Schieberegister sein, dessen Inhalt über Exklusiv-Oder-Verknüpfungen die Berechnung der Prüfsumme durchführt. Diese Möglichkeit scheidet in der Praxis jedoch wegen der zu großen Durchlaufzeiten der Exklusiv-Oder-Verknüpfungsmatrix aus.

Der Erfindung liegt die Aufgabe zugrunde, ein Verfahren und eine Vorrichtung zur Durchführung des Verfahrens zu schaffen, die mit geringem Schaltungsaufwand eine schnelle Bestimmung des Datenblockanfangs bei gleichzeitiger Auswertung der Prüfsumme ermöglicht.

Diese Aufgabe wird bei einem Verfahren nach dem Oberbegriff des Anspruchs 1 durch die im Kennzeichen des Anspruchs 1 angegebenen Merkmale und bei einer Vorrichtung zur Durchführung des Verfahrens nach dem Oberbegriff des Anspruchs 3 durch die im Kennzeichen des Anspruchs 3 angegebenen Merkmale gelöst.

Durch Modellberechnungen der Prüfsummen aufeinanderfolgender Datenblöcke wurde festgestellt, daß die Prüfsumme eines nachfolgenden Datenblocks nur durch das erste Bit des vorangehenden Datenblocks beeinflußt wird und sich systematisch nur auf einzelne Bit der Prüfsumme auswirkt. Die Findung dieses Zusammenhangs von aufeinanderfolgenden Datenblöcken ermöglicht nach vorheriger Bestimmung der änderungsfähigen Bits den Einfluß des ersten Bits eines vorangehenden Datenblocks auf die Prüfsumme zu eliminieren.

Bei einer Vorrichtung zur Durchführung des Verfahrens erfolgt dies durch ein Flip-Flop-Schieberegister, bei dem die Speicherinhalte der Flip-Flops mit den änderungsfähigen Bits in Abhängigkeit des ersten Bits eines vorangehenden Datenblocks beeinflußt werden. So kann das erste Bit des vorangehenden Datenblocks z. B. durch Exklusiv-Oder-Verknüpfungen aus dem Schieberegister entfernt werden.

Nachfolgend werden Verfahren und Vorrichtung anhand der Beschreibung des Aufbaus von ATM-Headern und der Auffindung des ATM-Zellenbeginns mittels einer in der Zeichnung dargestellten Schaltung und Datentabellen erläutert.

In der Zeichnung zeigen:

Fig. 1    ein Schieberegister zur Ermittlung einer Prüfsumme,

Fig. 2    eine Darstellung mehrerer aufeinanderfolgenden Datenblöcke der Informationsbit des Header eines Datenstroms,

| Fig. 3 | eine Tabelle mit den Ausgangsdaten des Schieberegisters gemäß Fig. 1 in Abhängigkeit von den Eingangsdaten eines ersten Datenblocks nach dem 31. Takt, |
|---|---|
| Fig. 4 | eine Tabelle ähnlich Fig. 3, jedoch nach dem 32. Takt, |
| Fig. 5 | eine Tabelle ähnlich Fig. 3, jedoch in Abhängigkeit von den Eingangsdaten eines zweiten Datenblocks nach dem 31. Takt, |
| Fig. 6 | eine Tabelle mit einem Vergleich der Ausgangsdaten des Schieberegisters gemäß Fig. 1 in Abhängigkeit von den Eingangsdaten eines ersten und eines zweiten Datenblocks zum gleichen Zeitpunkt und |
| Fig. 7 | ein Blockschaltbild zum Auffinden eines ATM-Zellenbeginns. |

Der Header jeder ATM-Zelle wird durch vier Informationsbytes entsprechend 32 Informationsbit und durch das berechnete Byte entsprechend acht Bit des Prüfsummenfeldes, insgesamt also durch fünf Byte gebildet. Die Berechnung der Prüfsumme erfolgt nach dem CRC (Cyclic Redundancy Check)-Kodierungsverfahren. Aus den ersten 32 Bit des Headers wird ein Polynom mit dem Grad 31 gebildet und mit $x^8$ multipliziert. Das so gebildete Code-Polynom mit dem Grad 39 wird nun durch das Generator-Polynom $g(x) = x^8 + x^2 + x + 1$ modulo 2 dividiert. Der Rest dieser Division stellt die Header-Prüfsumme dar. Da das Header-Prüfsummenfeld nicht nur der Fehlererkennung dient, sondern auch zur Detektierung und Synchronisation auf den Zellenanfang genutzt wird, wird zusätzlich zur Erhöhung der Zuverlässigkeit der Zellensynchronisation zur berechneten Prüfsumme die Bitfolge 01010101 (HEX 55) modulo 2 addiert, und als fünftes und letztes Byte des Headers übertragen.

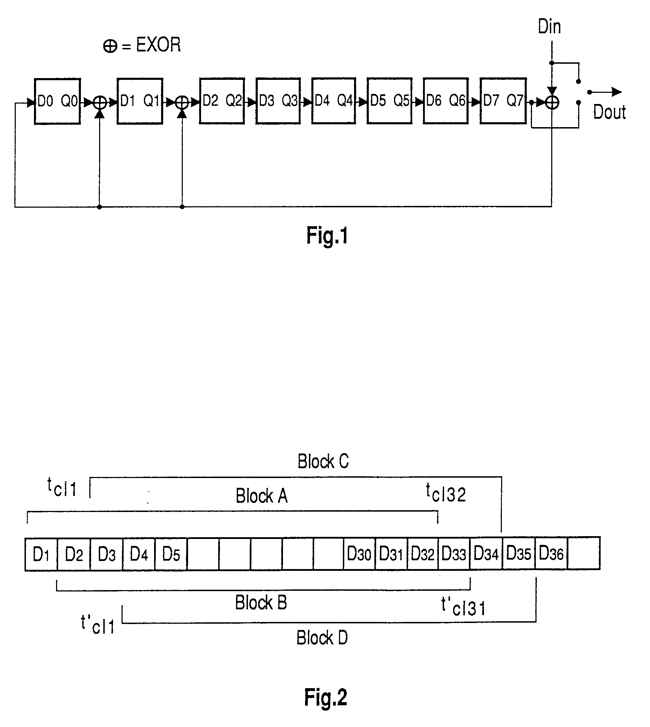

Die Berechnung der Prüfsumme erfolgt mit einer einfachen Flip-Flop-Schieberegister-Anordnung nach Fig. 1. Dabei werden die Bit Din des Datenstroms nach Exklusiv-Oder-Verknüfung mit dem Ausgang Q7 des achten Flip-Flops dem Eingang D0 der ersten Flip-Flops direkt und den Eingängen D1 und D2 des zweiten und dritten Flip-Flops nach Exklusiv-Oder-Verknüfung mit jeweils dem Ausgang Q0 des ersten und dem Ausgang Q1 des zweiten Flip-Flops zugeführt.

Wie aus Fig. 1 zu ersehen ist, ergibt sich aufgrund des Generatorpolynoms folgende Bildungsvorschrift für die 8 Bit Prüfsumme:

$$Q0_n = Q7_{n-1} \text{ EXOR } Din_n$$
$$Q1_n = Q7_{n-1} \text{ EXOR } Din_n \text{ EXOR } Q0_{n-1}$$
$$Q2_n = Q7_{n-1} \text{ EXOR } Din_n \text{ EXOR } Q1_{n-1}$$
$$Q3_n = Q2_{n-1}$$
$$Q4_n = Q3_{n-1}$$
$$Q5_n = Q4_{n-1}$$
$$Q6_n = Q5_{n-1}$$
$$Q7_n = Q6_{n-1}$$

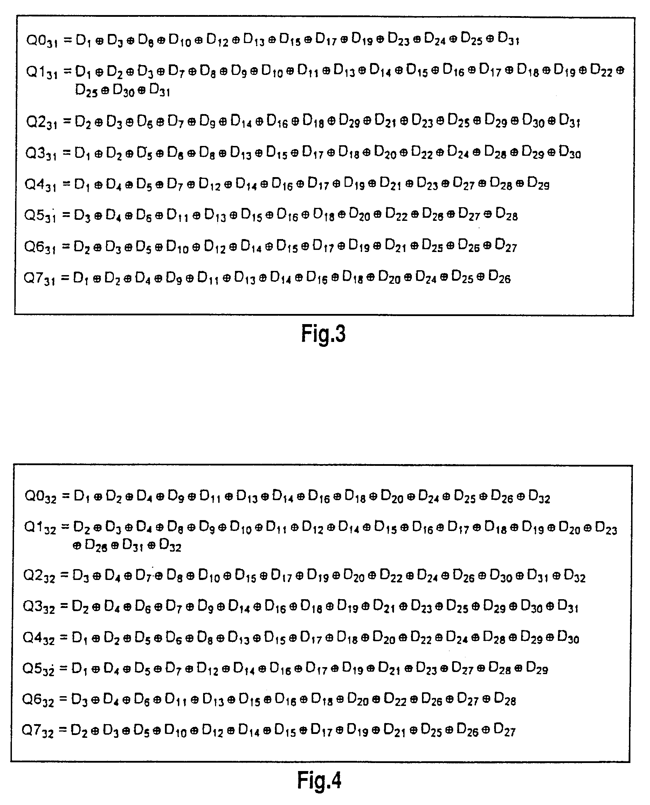

Führt man diese Vorschrift über 32 Takte durch, so erkennt man, welche empfangenen Datenbits $Din_n$ den Inhalt der einzelnen Schieberegister-Bits festlegen. Dieser Zusammenhang ist für einen ersten Datenblock A gemäß Fig. 2, der hier lediglich eine Länge entsprechend der 32 Informationsbit des Header aufweist, in der Tabelle gemäß Fig. 3 nach dem 31. Takt und in der Tabelle gemäß Fig. 4 nach dem 32. Takt dargestellt. Die Exklusiv-Oder-Verknüpfung ist in den Tabellen durch das Zeichen "###" dargestellt.

Sollte nach 32 Takten keine Gleichheit der auf der Empfangsseite berechneten und der empfangenen Daten unter Berücksichtigung der obigen Verknüpfung der Bitfolge gegeben sein, so muß das 32 Bit-Feld um einen Takt verschoben werden, um erneut die Prüfsumme für das verschobene Feld, in Fig. 2 als Block B dargestellt, zu berechnen.

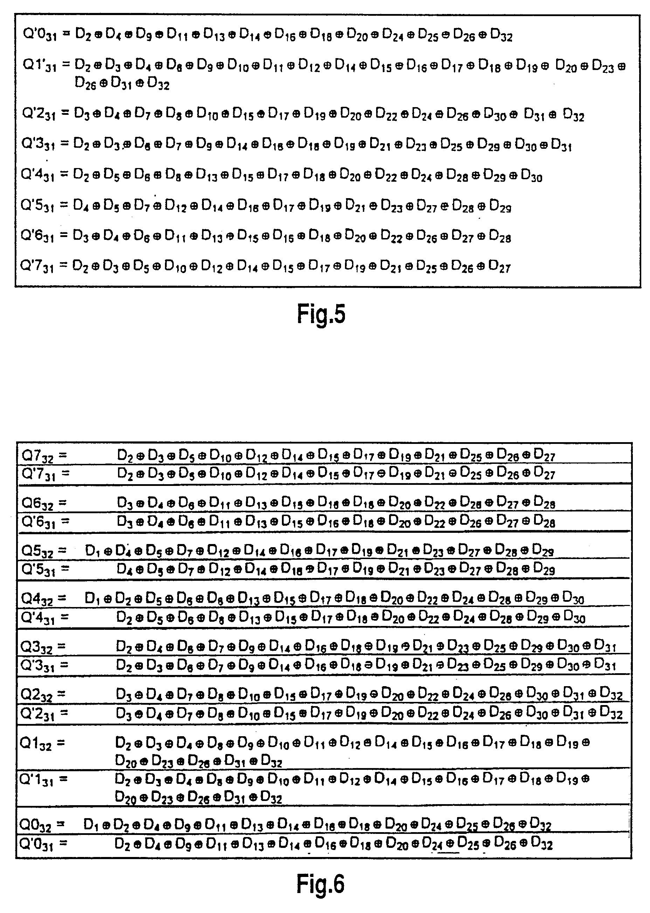

Unter der Annahme, daß Block A mit $Din = D1$ beginnt, beginnt Block B wegen der Verschiebung um einen Takt mit $Din = D2$, also um einen Index höher. Der Inhalt der Schieberegister für Block B kann somit aus dem Inhalt der Schieberegister für Block A in einfacher Weise dadurch bestimmt werden, daß jeweils für dieselbe Anzahl Takte die Indizes der Eingangsdaten gegenüber denen von Block A um eins erhöht werden. Dieser Zusammenhang ist in der Tabelle gemäß Fig. 5 für Block B nach dem 31. Takt dargestellt. Die Tabelle in Fig. 5 für Block B entspricht somit der Tabelle in Fig. 3 für Block A mit dem Unterschied, daß in Fig. 5 die Indizes der Eingangsdaten gegenüber Fig. 3 um eins erhöht sind.

Da der Inhalt der Flip-Flops des Schieberegisters nach dem 32. Takt für Block A demjenigen nach dem 31. Takt für Block B entspricht, kann durch Vergleich der Tabellen gemäß Fig. 4 und Fig. 5 ermittelt werden, welche Datenbits welche Flip-Flop-Inhalte beeinflussen. In der Tabelle gemäß Fig. 6 ist dieser Zusammenhang für den Zeitpunkt $t_{c132}$ nach dem 32. Takt für Block A ($Qm_{32}$ mit $m = 0...7$) in der jeweils oberen Zeile und für den Zeitpunkt $t_{c131}$ nach dem 31. Takt für Block B ($Q'm_{31}$ mit $m = 0...7$) in der jeweils unteren Zeile dargestellt. Durch Vergleich der jeweils unteren mit der jeweils oberen Zeile zeigt sich, daß sich lediglich der Inhalt der Flip-Flops Q0 - Q'0, Q4 - Q'4 und Q5 - Q'5 durch die Information des ersten Datenbits D1 unterscheiden, während der Inhalt der restlichen Flip-Flops für beide Datenblöcke identisch ist, wie nachfolgend gezeigt:

$$Q7_{32} = Q'7_{31}$$
$$Q6_{32} = Q'6_{31}$$
$$Q5_{32} = D1 \text{ EXOR } Q'5_{31}$$
$$Q4_{32} = D1 \text{ EXOR } Q'4_{31}$$
$$Q3_{32} = Q'3_{31}$$
$$Q2_{32} = Q'2_{31}$$
$$Q1_{32} = Q'1_{31}$$
$$Q0_{32} = D1 \text{ EXOR } Q'0_{31}$$

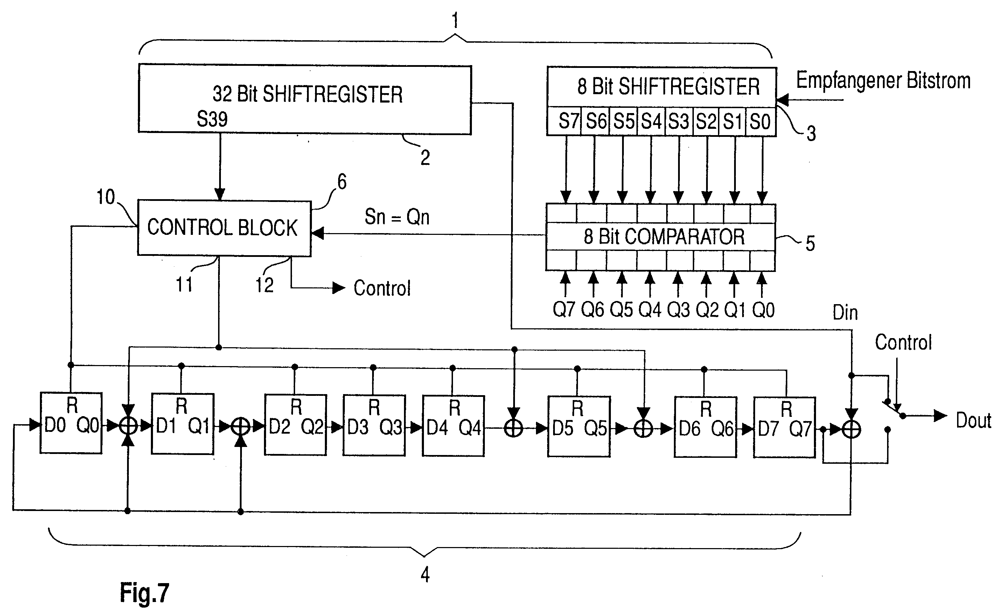

Das Erkennen dieses Zusammenhangs von aufeinanderfolgenden Blöcken ermöglicht erfindungsgemäß die Realisierung eines Verfahrens und einer Schaltung, durch die mit demselben Schieberegister gemäß Fig. 1 die neue Prüfsumme nach jedem weiteren Takt sofort zu ermitteln ist. Denn nun kann, wenn mit dem 32. Bit von Block A keine Identität mit der empfangenen Prüfsumme besteht, additiv der Einfluß von Bit D1 des Blocks A auf den Inhalt der Flip-Flops im nachfolgenden Takt durch Inversion des Ausgangssignals der Flip-Flops Q0, Q4 und Q5, falls D1 high Level im Block A hatte, eliminiert werden, und somit die korrekte Prüfsumme der Eingangsdaten D2 bis D33 für den Block B bestimmt werden. Das Bit D1 steht zum Zeitpunkt $t_{c132} = t'_{c131}$ am Ausgang S39 eines Schieberegisters zur Verfügung, wie es in der nachfolgend beschriebenen und in Fig. 7 dargestellten Schaltung enthalten ist.

Die Schaltung umfaßt ein erstes Schieberegister 1 mit vierzig Speicherzellen, in das der empfangene Datenstrom seriell eingeschrieben wird. Das erste Schieberegister 1 ist in einen 32 Bit-Bereich 2 für die vier Byte Informationsdaten eines Headers und einen acht Bit-Bereich 3 für das ein Byte lange Prüfsummenfeld des Headers unterteilt.

Ein zweites mit Flip-Flops aufgebautes Schieberegister 4 mit acht Speicherzellen dient zur Berechnung der Prüfsumme aus den Informationsbits des Headers. In das zweite Schieberegister 4 werden die Bit der achten Speicherzelle als Daten D*in* vom Ausgang S7 des acht Bit-Bereichs 3 des ersten Schieberegister 1 eingeschrieben. Dabei werden die Daten D*in* exklusiv-oder-verknüpfung mit dem Ausgang Q7 des achten Flip-Flops dem Eingang D0 des ersten Flip-Flops direkt sowie dem Eingang D1 des zweiten Flip-Flops exklusiv-oder-verknüpft mit dem Ausgang Q0 des ersten Flip-Flops und dem Eingang D2 des dritten Flip-Flops exklusiv-oder-verknüpft mit dem Ausgang Q1 des zweiten Flip-Flops zugeführt.

Die Schaltung umfaßt ferner einen acht Bit-Vergleicher 5, dessen Eingänge einerseits mit Ausgängen S0 ... S7 der ersten acht Speicherzellen des acht Bit-Bereichs 3 des ersten Schieberegisters 1 und andererseits mit den Ausgängen Q0 ... Q7 des zweiten Flip-Flop-Schieberegisters 4 verbunden sind. Ein Vergleichsausgang des Vergleichers 5 sowie der Ausgang S39 der letzten Speicherzelle des 32 Bit-Bereichs 2 des ersten Schieberegisters 1 sind mit einer Steuerschaltung 6 verbunden. Ein Ausgang 10 der Steuerschaltung 6 ist mit Rücksetzeingängen R der Flip-Flops des zweiten Schieberegisters 4 verbunden.

Zu Beginn des Suchalgorithmus werden die Flip-Flops des Schieberegisters 4 durch die Steuerschaltung 6 über den Ausgang 10 auf Null gesetzt. Anschließend werden Daten eingelesen, die Prüfsumme gebildet und im Vergleicher 5 überprüft. Bei Ungleichheit wird mit dem Bit der letzten Speicherzelle des ersten Schieberegisters 1 am Ausgang S39 ein weiterer Ausgang 11 der Steuerschaltung 6 aktiviert. Dadurch wird der Ausgang S39 der letzten Speicherzelle des ersten Schieberegisters 1 mit dem Eingang D1 des zweiten Flip-Flops unter Exklusiv-Oder-Verknüpfung des Ausgangs Q0 des ersten Flip-Flops, mit dem Eingang D5 des sechsten Flip-Flops unter Exklusiv-Oder-Verknüpfung des Ausgangs Q4 des fünften Flip-Flops und mit dem Eingang D6 des siebenten Flip-Flops unter Exklusiv-Oder-Verknüpfung des Ausgangs Q5 des sechsten Flip-Flops des Flip-Flop-Schieberegisters 4 verbunden. Durch diese Exklusiv-Oder-Verknüpfung wird der Einfluß von Bit D1 des vorangehenden Blocks auf den Inhalt der Flip-Flops im nachfolgenden Takt durch Inversion jeweils additiv eliminiert.

Sollte im Block B wiederum keine Koinzidenz erreicht werden, so wird der beschriebene Algorithmus solange wiederholt, bis eine Übereinstimmung im Vergleicher 5, entsprechend Sn = Qn, zwischen empfängerseitig errechneter und empfangener Header-Prüfsumme besteht. Damit kann dann der Suchvorgang des Zellenanfangs beendet werden und die Schaltung kann durch ein an einem dritten Ausgang 12 der Steuerschaltung 6 aktiviertes Signal "CONTROL" in den PRESYNCH Zustand übergehen.

## Patentansprüche

1. Verfahren zum Verifizieren der Prüfsumme eines aus Informationsdaten und einem anschließenden Prüfsummenfeld bestehenden empfangenen Datenblocks, wobei die Prüfsumme senderseitig nach einer Bildungsvorschrift aus den Informationsdaten des Datenblocks gebildet ist, indem aus n aufeinanderfolgenden Bit der Informationsdaten ein Polynom mit dem Grad n-1 gebildet, das Polynom mit $x_m$ multipliziert wird, das erhaltene Produkt mit dem Grad

n-1+m durch ein Generatorpolynom $g(x) = a_m x^m + a_{m-1}{}^* x^{m-1} + a_{m-2}{}^* x^{m-2} + ... + a_1{}^* x + a_0$ modulo 2 dividiert wird, und der Rest der Division zuzüglich einer Konstante als Prüfsumme mit o Bit in das Prüfsummenfeld gesetzt wird und empfängerseitig aufeinanderfolgende Bits der Anzahl eines Datenblockes jeweils ausgewertet werden, indem aus den ersten n aufeinanderfolgenden Bits eine Prüfsumme nach derselben Bildungsvorschrift ermittelt und mit einem Vergleichswert verglichen wird, der in den restlichen nachfolgenden Bits enthalten ist, **dadurch gekennzeichnet**, daß, solange Ungleichheit zwischen der ermittelten Prüfsumme und dem Vergleichswert herrscht, mit jedem weiteren Takt eine neue Prüfsumme gewonnen wird, indem nur die in Vorberechnungen in Abhängigkeit des gewählten Generatorpolynoms als änderungsfähig ermittelten Bits der vorangehenden Prüfsumme ausgewählt und zur Bildung der neuen Prüfsumme mit dem zuerst gesendeten Bits des jeweils vorangehenden Datenblocks logisch verknüpft werden.

2. Verfahren nach Anspruch 1, wobei der Datenblock aus vier Byte mit je acht Bit Informationsdaten und einem nachfolgenden Prüfsummenfeld aus einem Byte mit acht Bit besteht, das Generatorpolynom $g(x) = x^8 + x^2 + x + 1$ modulo 2 ist und die Konstante die Bitfolge 01010101 umfaßt, **dadurch gekennzeichnet**, daß als änderungsfähige Bits der Prüfsumme die Bits mit den Wertigkeiten $x^0$, $x^4$ und $x^5$ mit dem zuerst gesendeten Bit des jeweils vorangehenden Datenblocks durch eine Exklusiv-Oder-Verknüpfung logisch verknüpft werden.

3. Vorrichtung zur Durchführung des Verfahrens nach Anspruch 1, bestehend aus einem ersten Schieberegister (1) mit n + o Speicherzellen, in das der empfangene Datenstrom seriell eingeschrieben wird, einem zweiten Flip-Flop-Schieberegister (4) mit o Speicherzellen zur Berechnung der Prüfsumme, in das die Bit der o-ten Speicherzelle des ersten Schieberegisters (1) unter logischer Verknüpfung mit dem Generatorpolynom eingeschrieben werden, und einem o-Bit Vergleicher (5), dessen Eingänge einerseits mit Ausgängen der ersten o Speicherzellen des ersten Schieberegisters (1) und andererseits mit den Ausgängen des zweiten Flip-Flop-Schieberegisters (4) verbunden sind, **dadurch gekennzeichnet**, daß ein Vergleichsausgang des Vergleichers (5) sowie der Ausgang der letzten Speicherzelle (S39) des ersten Schieberegisters (1) mit einer Steuerschaltung (6) verbunden sind, daß ein Ausgang (10) der Steuerschaltung (6) mit Rücksetzeingängen (R) der Flip-Flops des Flip-Flop-Schieberegisters (4) und ein Ausgang (11) der Steuerschaltung (6), der bei Ungleichheit im Vergleicher (5) mit dem Bit der letzten Speicherzelle (S39) des ersten Schieberegisters (1) aktiviert wird, über logische Verknüpfungsglieder mit den Ausgängen der die änderungsfähigen Bits der Prüfsumme enthaltenden Flip-Flops und den Eingängen der diesen folgenden Flip-Flops des Flip-Flop-Schieberegisters (4) verbunden sind.

4. Vorrichtung zur Durchführung des Verfahrens nach Anspruch 2, bestehend aus einem ersten Schieberegister (1) mit vierzig Speicherzellen, in das der empfangene Datenstrom seriell eingeschrieben wird, einem zweiten Flip-Flop-Schieberegister (4) mit acht Speicherzellen zur Berechnung der Prüfsumme, in das die Bit der achten Speicherzelle (S7) des ersten Schieberegisters (1) eingeschrieben werden, indem das Bit der achten Speicherzelle des ersten Schieberegisters (1) exklusiv-oder-verknüpft mit dem Ausgang (Q7) des achten Flip-Flops dem Eingang (D0) des ersten Flip-Flops direkt sowie dem Eingang (D1) des zweiten Flip-Flops exklusiv-oder-verknüpft mit dem Ausgang (Q0) des ersten Flip-Flops und dem Eingang (D2) des dritten Flip-Flops exklusiv-oder-verknüpft mit dem Ausgang (Q1) des zweiten Flip-Flops zugeführt wird, bestehend ferner aus einem acht Bit-Vergleicher (5), dessen Eingänge einerseits mit Ausgängen (S0 ... S7) der ersten acht Speicherzellen des ersten Schieberegisters (1) und andererseits mit den Ausgängen (Q0 ... Q7) des zweiten Flip-Flop-Schieberegisters (4) verbunden sind, **dadurch gekennzeichnet**, daß ein Vergleichsausgang des Vergleichers (5) sowie ein Ausgang der letzten Speicherzelle (S39) des ersten Schieberegisters (1) mit einer Steuerschaltung (6) verbunden sind, daß ein Ausgang (10) der Steuerschaltung (6) mit Rücksetzeingängen (R) der Flip-Flops des Flip-Flop-Schieberegisters (4) verbunden ist und ein bei Ungleichheit im Vergleicher (5) mit dem Bit der letzten Speicherzelle (S39) des ersten Schieberegisters (1) aktivierter Ausgang (11) der Steuerschaltung (6) mit dem Eingang (D1) des zweiten Flip-Flops unter Exklusiv-Oder-Verknüpfung des Ausgangs (Q0) des ersten Flip-Flops, mit dem Eingang (D5) des sechsten Flip-Flops unter Exklusiv-Oder-Verknüpfung des Ausgangs (Q4) des fünften Flip-Flops und mit dem Eingang (D6) des siebenten Flip-Flops unter Exklusiv-Oder-Verknüpfung des Ausgangs (Q5) des sechsten Flip-Flops des Flip-Flop-Schieberegisters (4) verbunden ist.

⊕ = EXOR

Din

| D0 Q0 | ⊕ | D1 Q1 | ⊕ | D2 Q2 | D3 Q3 | D4 Q4 | D5 Q5 | D6 Q6 | D7 Q7 | ⊕ |

Dout

**Fig.1**

Block C

$t_{cl1}$          Block A          $t_{cl32}$

| D1 | D2 | D3 | D4 | D5 | | | | | | D30 | D31 | D32 | D33 | D34 | D35 | D36 | |

Block B          $t'_{cl31}$

$t'_{cl1}$

Block D

**Fig.2**

$Q0_{31} = D_1 \oplus D_3 \oplus D_8 \oplus D_{10} \oplus D_{12} \oplus D_{13} \oplus D_{15} \oplus D_{17} \oplus D_{19} \oplus D_{23} \oplus D_{24} \oplus D_{25} \oplus D_{31}$

$Q1_{31} = D_1 \oplus D_2 \oplus D_3 \oplus D_7 \oplus D_8 \oplus D_9 \oplus D_{10} \oplus D_{11} \oplus D_{13} \oplus D_{14} \oplus D_{15} \oplus D_{16} \oplus D_{17} \oplus D_{18} \oplus D_{19} \oplus D_{22} \oplus D_{25} \oplus D_{30} \oplus D_{31}$

$Q2_{31} = D_2 \oplus D_3 \oplus D_5 \oplus D_7 \oplus D_9 \oplus D_{14} \oplus D_{16} \oplus D_{18} \oplus D_{29} \oplus D_{21} \oplus D_{23} \oplus D_{25} \oplus D_{29} \oplus D_{30} \oplus D_{31}$

$Q3_{31} = D_1 \oplus D_2 \oplus D_5 \oplus D_6 \oplus D_8 \oplus D_{13} \oplus D_{15} \oplus D_{17} \oplus D_{18} \oplus D_{20} \oplus D_{22} \oplus D_{24} \oplus D_{28} \oplus D_{29} \oplus D_{30}$

$Q4_{31} = D_1 \oplus D_4 \oplus D_5 \oplus D_7 \oplus D_{12} \oplus D_{14} \oplus D_{16} \oplus D_{17} \oplus D_{19} \oplus D_{21} \oplus D_{23} \oplus D_{27} \oplus D_{28} \oplus D_{29}$

$Q5_{31} = D_3 \oplus D_4 \oplus D_6 \oplus D_{11} \oplus D_{13} \oplus D_{15} \oplus D_{16} \oplus D_{18} \oplus D_{20} \oplus D_{22} \oplus D_{26} \oplus D_{27} \oplus D_{28}$

$Q6_{31} = D_2 \oplus D_3 \oplus D_5 \oplus D_{10} \oplus D_{12} \oplus D_{14} \oplus D_{15} \oplus D_{17} \oplus D_{19} \oplus D_{21} \oplus D_{25} \oplus D_{26} \oplus D_{27}$

$Q7_{31} = D_1 \oplus D_2 \oplus D_4 \oplus D_9 \oplus D_{11} \oplus D_{13} \oplus D_{14} \oplus D_{16} \oplus D_{18} \oplus D_{20} \oplus D_{24} \oplus D_{25} \oplus D_{26}$

## Fig.3

$Q0_{32} = D_1 \oplus D_2 \oplus D_4 \oplus D_9 \oplus D_{11} \oplus D_{13} \oplus D_{14} \oplus D_{16} \oplus D_{18} \oplus D_{20} \oplus D_{24} \oplus D_{25} \oplus D_{26} \oplus D_{32}$

$Q1_{32} = D_2 \oplus D_3 \oplus D_4 \oplus D_8 \oplus D_9 \oplus D_{10} \oplus D_{11} \oplus D_{12} \oplus D_{14} \oplus D_{15} \oplus D_{16} \oplus D_{17} \oplus D_{18} \oplus D_{19} \oplus D_{20} \oplus D_{23} \oplus D_{26} \oplus D_{31} \oplus D_{32}$

$Q2_{32} = D_3 \oplus D_4 \oplus D_7 \oplus D_8 \oplus D_{10} \oplus D_{15} \oplus D_{17} \oplus D_{19} \oplus D_{20} \oplus D_{22} \oplus D_{24} \oplus D_{26} \oplus D_{30} \oplus D_{31} \oplus D_{32}$

$Q3_{32} = D_2 \oplus D_4 \oplus D_6 \oplus D_7 \oplus D_9 \oplus D_{14} \oplus D_{16} \oplus D_{18} \oplus D_{19} \oplus D_{21} \oplus D_{23} \oplus D_{25} \oplus D_{29} \oplus D_{30} \oplus D_{31}$

$Q4_{32} = D_1 \oplus D_2 \oplus D_5 \oplus D_6 \oplus D_8 \oplus D_{13} \oplus D_{15} \oplus D_{17} \oplus D_{18} \oplus D_{20} \oplus D_{22} \oplus D_{24} \oplus D_{28} \oplus D_{29} \oplus D_{30}$

$Q5_{32} = D_1 \oplus D_4 \oplus D_5 \oplus D_7 \oplus D_{12} \oplus D_{14} \oplus D_{16} \oplus D_{17} \oplus D_{19} \oplus D_{21} \oplus D_{23} \oplus D_{27} \oplus D_{28} \oplus D_{29}$

$Q6_{32} = D_3 \oplus D_4 \oplus D_6 \oplus D_{11} \oplus D_{13} \oplus D_{15} \oplus D_{16} \oplus D_{18} \oplus D_{20} \oplus D_{22} \oplus D_{26} \oplus D_{27} \oplus D_{28}$

$Q7_{32} = D_2 \oplus D_3 \oplus D_5 \oplus D_{10} \oplus D_{12} \oplus D_{14} \oplus D_{15} \oplus D_{17} \oplus D_{19} \oplus D_{21} \oplus D_{25} \oplus D_{26} \oplus D_{27}$

## Fig.4

$$Q'0_{31} = D_2 \oplus D_4 \oplus D_9 \oplus D_{11} \oplus D_{13} \oplus D_{14} \oplus D_{16} \oplus D_{18} \oplus D_{20} \oplus D_{24} \oplus D_{25} \oplus D_{26} \oplus D_{32}$$

$$Q1'_{31} = D_2 \oplus D_3 \oplus D_4 \oplus D_8 \oplus D_9 \oplus D_{10} \oplus D_{11} \oplus D_{12} \oplus D_{14} \oplus D_{15} \oplus D_{16} \oplus D_{17} \oplus D_{18} \oplus D_{19} \oplus D_{20} \oplus D_{23} \oplus D_{26} \oplus D_{31} \oplus D_{32}$$

$$Q'2_{31} = D_3 \oplus D_4 \oplus D_7 \oplus D_8 \oplus D_{10} \oplus D_{15} \oplus D_{17} \oplus D_{19} \oplus D_{20} \oplus D_{22} \oplus D_{24} \oplus D_{26} \oplus D_{30} \oplus D_{31} \oplus D_{32}$$

$$Q'3_{31} = D_2 \oplus D_3 \oplus D_6 \oplus D_7 \oplus D_9 \oplus D_{14} \oplus D_{16} \oplus D_{18} \oplus D_{19} \oplus D_{21} \oplus D_{23} \oplus D_{25} \oplus D_{29} \oplus D_{30} \oplus D_{31}$$

$$Q'4_{31} = D_2 \oplus D_5 \oplus D_6 \oplus D_8 \oplus D_{13} \oplus D_{15} \oplus D_{17} \oplus D_{18} \oplus D_{20} \oplus D_{22} \oplus D_{24} \oplus D_{28} \oplus D_{29} \oplus D_{30}$$

$$Q'5_{31} = D_4 \oplus D_5 \oplus D_7 \oplus D_{12} \oplus D_{14} \oplus D_{16} \oplus D_{17} \oplus D_{19} \oplus D_{21} \oplus D_{23} \oplus D_{27} \oplus D_{28} \oplus D_{29}$$

$$Q'6_{31} = D_3 \oplus D_4 \oplus D_6 \oplus D_{11} \oplus D_{13} \oplus D_{15} \oplus D_{16} \oplus D_{18} \oplus D_{20} \oplus D_{22} \oplus D_{26} \oplus D_{27} \oplus D_{28}$$

$$Q'7_{31} = D_2 \oplus D_3 \oplus D_5 \oplus D_{10} \oplus D_{12} \oplus D_{14} \oplus D_{15} \oplus D_{17} \oplus D_{19} \oplus D_{21} \oplus D_{25} \oplus D_{26} \oplus D_{27}$$

**Fig.5**

| | |
|---|---|
| $Q7_{32} =$ | $D_2 \oplus D_3 \oplus D_5 \oplus D_{10} \oplus D_{12} \oplus D_{14} \oplus D_{15} \oplus D_{17} \oplus D_{19} \oplus D_{21} \oplus D_{25} \oplus D_{26} \oplus D_{27}$ |
| $Q'7_{31} =$ | $D_2 \oplus D_3 \oplus D_5 \oplus D_{10} \oplus D_{12} \oplus D_{14} \oplus D_{15} \oplus D_{17} \oplus D_{19} \oplus D_{21} \oplus D_{25} \oplus D_{26} \oplus D_{27}$ |
| $Q6_{32} =$ | $D_3 \oplus D_4 \oplus D_6 \oplus D_{11} \oplus D_{13} \oplus D_{15} \oplus D_{16} \oplus D_{18} \oplus D_{20} \oplus D_{22} \oplus D_{26} \oplus D_{27} \oplus D_{28}$ |
| $Q'6_{31} =$ | $D_3 \oplus D_4 \oplus D_6 \oplus D_{11} \oplus D_{13} \oplus D_{15} \oplus D_{16} \oplus D_{18} \oplus D_{20} \oplus D_{22} \oplus D_{26} \oplus D_{27} \oplus D_{28}$ |
| $Q5_{32} =$ | $D_1 \oplus D_4 \oplus D_5 \oplus D_7 \oplus D_{12} \oplus D_{14} \oplus D_{16} \oplus D_{17} \oplus D_{19} \oplus D_{21} \oplus D_{23} \oplus D_{27} \oplus D_{28} \oplus D_{29}$ |
| $Q'5_{31} =$ | $D_4 \oplus D_5 \oplus D_7 \oplus D_{12} \oplus D_{14} \oplus D_{16} \oplus D_{17} \oplus D_{19} \oplus D_{21} \oplus D_{23} \oplus D_{27} \oplus D_{28} \oplus D_{29}$ |
| $Q4_{32} =$ | $D_1 \oplus D_2 \oplus D_5 \oplus D_6 \oplus D_8 \oplus D_{13} \oplus D_{15} \oplus D_{17} \oplus D_{18} \oplus D_{20} \oplus D_{22} \oplus D_{24} \oplus D_{28} \oplus D_{29} \oplus D_{30}$ |
| $Q'4_{31} =$ | $D_2 \oplus D_5 \oplus D_6 \oplus D_8 \oplus D_{13} \oplus D_{15} \oplus D_{17} \oplus D_{18} \oplus D_{20} \oplus D_{22} \oplus D_{24} \oplus D_{28} \oplus D_{29} \oplus D_{30}$ |
| $Q3_{32} =$ | $D_2 \oplus D_4 \oplus D_6 \oplus D_7 \oplus D_9 \oplus D_{14} \oplus D_{16} \oplus D_{18} \oplus D_{19} \oplus D_{21} \oplus D_{23} \oplus D_{25} \oplus D_{29} \oplus D_{30} \oplus D_{31}$ |
| $Q'3_{31} =$ | $D_2 \oplus D_3 \oplus D_6 \oplus D_7 \oplus D_9 \oplus D_{14} \oplus D_{16} \oplus D_{18} \oplus D_{19} \oplus D_{21} \oplus D_{23} \oplus D_{25} \oplus D_{29} \oplus D_{30} \oplus D_{31}$ |
| $Q2_{32} =$ | $D_3 \oplus D_4 \oplus D_7 \oplus D_8 \oplus D_{10} \oplus D_{15} \oplus D_{17} \oplus D_{19} \oplus D_{20} \oplus D_{22} \oplus D_{24} \oplus D_{26} \oplus D_{30} \oplus D_{31} \oplus D_{32}$ |
| $Q'2_{31} =$ | $D_3 \oplus D_4 \oplus D_7 \oplus D_8 \oplus D_{10} \oplus D_{15} \oplus D_{17} \oplus D_{19} \oplus D_{20} \oplus D_{22} \oplus D_{24} \oplus D_{26} \oplus D_{30} \oplus D_{31} \oplus D_{32}$ |
| $Q1_{32} =$ | $D_2 \oplus D_3 \oplus D_4 \oplus D_8 \oplus D_9 \oplus D_{10} \oplus D_{11} \oplus D_{12} \oplus D_{14} \oplus D_{15} \oplus D_{16} \oplus D_{17} \oplus D_{18} \oplus D_{19} \oplus D_{20} \oplus D_{23} \oplus D_{26} \oplus D_{31} \oplus D_{32}$ |
| $Q'1_{31} =$ | $D_2 \oplus D_3 \oplus D_4 \oplus D_8 \oplus D_9 \oplus D_{10} \oplus D_{11} \oplus D_{12} \oplus D_{14} \oplus D_{15} \oplus D_{16} \oplus D_{17} \oplus D_{18} \oplus D_{19} \oplus D_{20} \oplus D_{23} \oplus D_{26} \oplus D_{31} \oplus D_{32}$ |
| $Q0_{32} =$ | $D_1 \oplus D_2 \oplus D_4 \oplus D_9 \oplus D_{11} \oplus D_{13} \oplus D_{14} \oplus D_{16} \oplus D_{18} \oplus D_{20} \oplus D_{24} \oplus D_{25} \oplus D_{26} \oplus D_{32}$ |
| $Q'0_{31} =$ | $D_2 \oplus D_4 \oplus D_9 \oplus D_{11} \oplus D_{13} \oplus D_{14} \oplus D_{16} \oplus D_{18} \oplus D_{20} \oplus D_{24} \oplus D_{25} \oplus D_{26} \oplus D_{32}$ |

**Fig.6**

Fig.7

EP 0 746 123 A1

| | Europäisches Patentamt | **EUROPÄISCHER RECHERCHENBERICHT** | Nummer der Anmeldung |
|---|---|---|---|
| | | | EP 96 10 8119 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | US-A-5 131 012 (DRAVIDA SUBRAHMANYAM) 14.Juli 1992 <br> * das ganze Dokument * <br> --- | 1-4 | H04J3/06 <br> H03M13/00 <br> H04L7/04 |
| A | EP-A-0 396 403 (STC PLC) 7.November 1990 <br> * Ansprüche 1-9; Abbildung 1 * <br> * Spalte 2, Zeile 44 - Spalte 3, Zeile 15 * <br> --- | 1-4 | |
| A | PATENT ABSTRACTS OF JAPAN <br> vol. 018, no. 486 (E-1604), 9.September 1994 <br> & JP-A-06 164624 (MATSUSHITA ELECTRIC IND CO LTD), 10.Juni 1994, <br> * Zusammenfassung * <br> --- | 1-4 | |
| P,X | WO-A-95 18495 (NEDERLAND PTT ;NIELANDER JOHAN WIEANT GERLACH (NL); VANKAN FRANCIS) 6.Juli 1995 <br> * Seite 13, Zeile 5 - Seite 14, Zeile 10; Abbildung 1 * <br> ----- | 1-4 | RECHERCHIERTE SACHGEBIETE (Int.Cl.6) <br><br> H04J <br> H03M <br> H04L |

Der vorliegende Recherchenbericht wurde für alle Patentansprüche erstellt

| Recherchenort | Abschlußdatum der Recherche | Prüfer |
|---|---|---|
| MÜNCHEN | 27.August 1996 | Farman, T |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

.............................................................................
& : Mitglied der gleichen Patentfamilie, übereinstimmendes Dokument

EPO FORM 1503 03.82 (P04C03)